(19) Europäisches Patentamt
European Patent Office
Office européen des brevets

(11) **EP 4 583 639 A1**

(12) **EUROPEAN PATENT APPLICATION**
published in accordance with Art. 153(4) EPC

(43) Date of publication:
**09.07.2025 Bulletin 2025/28**

(21) Application number: **23858842.0**

(22) Date of filing: **25.06.2023**

(51) International Patent Classification (IPC):
**H05K 1/02** (2006.01)

(52) Cooperative Patent Classification (CPC):
**H05K 1/02**

(86) International application number:
**PCT/CN2023/102207**

(87) International publication number:
**WO 2024/045803 (07.03.2024 Gazette 2024/10)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.08.2022 CN 202211058162**

(71) Applicant: **ZTE CORPORATION**
**Shenzhen, Guangdong 518057 (CN)**

(72) Inventor: **LI, Guochang**
**Shenzhen, Guangdong 518057 (CN)**

(74) Representative: **Chimini, Francesco et al**
**Jacobacci & Partners S.p.A.**
**Piazza della Vittoria 11**
**25122 Brescia (IT)**

(54) **PRINTED CIRCUIT BOARD, ELECTRONIC DEVICE, AND METHOD FOR CONTROLLING PROPAGATION DELAY SKEW OF DIFFERENTIAL PAIR**

(57) Embodiments of the present disclosure provide a printed circuit board, an electronic device, and a method for controlling a propagation delay skew of a differential pair. The printed circuit board includes a board body. The board body is provided with a first differential via, a second differential via, and at least one non-metallized hole, and the first differential via and the second differential via form a differential via pair. The at least one non-metallized hole is arranged around a periphery of the first differential via and/or a periphery of the second differential via, and the non-metallized holes around the periphery of the first differential via and the non-metallized holes around the periphery of the second differential via are asymmetrically arranged.

Fig.1

EP 4 583 639 A1

## Description

### Cross-Reference to Related Application

This disclosure claims priority to the Chinese patent application No.CN202211058162.1, entitled "PRINTED CIRCUIT BOARD, ELECTRONIC DEVICE, AND METHOD FOR CONTROLLING PROPAGATION DELAY SKEW OF DIFFERENTIAL PAIR", filed on August 30, 2022, the entire contents of which are incorporated herein by reference.

### Technical Field

The present disclosure relates to the technical field of circuit boards, and in particular, to a printed circuit board, an electronic device, and a method for controlling a propagation delay skew of a differential pair.

### Background

A printed circuit board (PCB) serves as a primary carrier for signal transmission in a communication device product. As signal rates continue to increase, long-distance and high-quality signal transmission has become a challenging problem in the industry. One of main factors affecting the signal quality in long-distance transmission is impedance mismatch in a link and the impact of crosstalk. During signal transmission, a via structure is a common structure causing impedance discontinuity in the link. Due to the robustness and strong anti-interference capability of differential signals, differential vias are basically used for signal transmission in a high-speed system. However, as system rates continue to rise, existing printed circuit boards including differential vias exhibit a significant propagation delay skew.

### Summary

The present disclosure provides a printed circuit board, an electronic device, and a method for controlling a propagation delay skew of a differential pair, to reduce a propagation delay skew of differential signals.

According to a first aspect of the present disclosure, the present disclosure provides a printed circuit board, including a board body. The board body is provided with a first differential via, a second differential via, and at least one non-metallized hole, and the first differential via and the second differential via form a differential via pair.

The at least one non-metallized hole is arranged around a periphery of the first differential via and/or a periphery of the second differential via, and the non-metallized holes around the periphery of the first differential via and the non-metallized holes around the periphery of the second differential via are asymmetrically arranged.

According to a second aspect of the present disclosure, the present disclosure further provides a method for controlling a propagation delay skew of a differential pair on a printed circuit board, including: arranging at least one non-metallized hole around a periphery of a first differential via and/or a periphery of a second differential via, the first differential via and the second differential via forming a differential via pair, and the non-metallized holes around the periphery of the first differential via and the non-metallized holes around the periphery of the second differential via being asymmetrically arranged.

According to a third aspect of the present disclosure, the present disclosure further provides an electronic device, including the above printed circuit board.

### Brief Description of the Drawings

In order to describe the technical solutions of the embodiments of the present disclosure more clearly, the accompanying drawings required for describing the embodiments will be briefly introduced below. Apparently, the accompanying drawings in the following description are some embodiments of the present disclosure, and those of ordinary skill in the art may also obtain other accompanying drawings according to these accompanying drawings without creative efforts.

Fig. 1 is a schematic diagram of a structure of a printed circuit board according to an embodiment of the present disclosure;

Fig. 2 is a cross-sectional view of the printed circuit board shown in Fig. 1;

Fig. 3 is a schematic diagram of a structure of a printed circuit board according to an embodiment of the present disclosure;

Fig. 4 is a schematic diagram of a structure of a printed circuit board according to an embodiment of the present disclosure;

Fig. 5 is a schematic diagram of a structure of a printed circuit board according to an embodiment of the present disclosure;

Fig. 6 is a schematic diagram of a structure of a printed circuit board according to an embodiment of the present disclosure;

Fig. 7 is a schematic diagram of a structure of a printed circuit board according to an embodiment of the present disclosure;

Fig. 8 is a cross-sectional view of the printed circuit board shown in Fig. 7;

Fig. 9 is a schematic diagram of a structure of a printed circuit board according to an embodiment of the present disclosure;

Fig. 10 is a cross-sectional view of the printed circuit board shown in Fig. 9;

Fig. 11 is a mode conversion diagram for a control group and a printed circuit board according to an embodiment of the present disclosure; and

Fig. 12 is an impedance diagram for a control group and a printed circuit board according to an embodiment of the present disclosure.

Descriptions of reference numerals:
10-board body; 11-reference structure; 12-dielectric medium; 20-first differential via; 30-second differential via; 40-non-metallized hole; 41-first non-metallized hole; 42-second non-metallized hole; 50-differential line pair; 51-first differential line; and 52-second differential line.

**Detailed Description of the Embodiments**

The technical solutions in the embodiments of the present disclosure will be clearly and completely described below with reference to the accompanying drawings in the embodiments of the present disclosure, and it is apparent that the described embodiments are a part rather than all of the embodiments of the present disclosure. Based on the embodiments of the present disclosure, all other embodiments obtained by those of ordinary skill in art without creative work shall fall within the scope of protection of the present disclosure.

In the description of the present disclosure, it should be understood that orientation or position relationships indicated by the terms such as "center", "longitudinal", "transverse", "length", "width", "thickness", "upper", "lower", "front", "back", "left", "right", "vertical", "horizontal", "top", "bottom", "inside", "outside", "clockwise", and "anticlockwise", are based on orientation or position relationships shown in the accompanying drawings, and are intended to facilitate the description of the present disclosure and simplify the description only, rather than indicate or imply that an apparatus or element referred needs to have a particular orientation or be constructed and operated in a particular orientation. Therefore, such terms should not be construed as limiting the present disclosure. Additionally, the terms "first" and "second" are used merely for the purpose of description, and should not be construed as indicating or implying relative importance or implying a quantity of indicated technical features. Therefore, features defined as "first" and "second" may explicitly or implicitly include one or more of the features. In the descriptions of the present disclosure, unless otherwise explicitly limited, "a plurality of" means two or more than two.

It should also be understood that the terms used in the specification of the present disclosure are merely for the purpose of describing the specific embodiments and are not intended to limit the present disclosure. As used in the specification of the present disclosure and the appended claims, unless the context clearly indicates otherwise, the singular forms "a", "an", and "the" are intended to include the plural forms.

It should be further understood that the term "and/or" used in the specification and the appended claims of the present disclosure refers to one of or any combination of more of associated listed items and all possible combinations thereof, and these combinations are included.

A printed circuit board (PCB) serves as a primary carrier for signal transmission in a communication device product. During signal transmission, a via structure is a common structure causing impedance discontinuity in a link. Due to the robustness and strong anti-interference capability of differential signals, differential vias are basically used for signal transmission in a high-speed system.

In the system link, a differential pair includes a differential via pair, a first transmission line, and a second transmission line. The differential via pair includes a differential via P and a differential via N. The first transmission line is connected with the differential via P, and the second transmission line is connected with the differential via N. Due to the layout of a chip, a connector, and other components, as well as a line-out method of a component pin, routing lengths of the first transmission line and the second transmission line are not consistent, leading to the existence of a propagation delay skew. A calculation formula of the differential pair skew is

$$t_{skew} = t_p - t_n = l_p \sqrt{\varepsilon_p} \, / \, c - l_n \sqrt{\varepsilon_n} \, / \, c$$

, where $t_p$ denotes a transmission delay of the differential via P and the first transmission line, $t_n$ denotes a propagation delay of the differential via N and the second transmission line, $\varepsilon_p$ and $\varepsilon_n$ are respectively effective dielectric constants of media surrounding the differential via P and the differential via N, $l_p$ and $l_n$ respectively denote routing lengths of the first transmission line and the second transmission line, and c denotes a propagation speed of light in air. An existing method for reducing the above skew primarily involves winding around line-out positions of the differential vias and adjusting the routing lengths of the first transmission line and the second transmission line outside the component to make $l_p = l_n$. A fan-out method is adjusted at the line-out positions of the differential vias, thereby ensuring equal routing lengths at the fan-out positions. However, as a system rate continues to increase, 0.6 mm pitch signal hole spacing is becoming more common. Due to manufacturing constraints, the fan-out positions of the differential vias cannot be adjusted to be of equal length, and the method for winding around the pin may introduce wire puncturing or crosstalk from pads. Additionally, adjusting the lengths to be equal outside the component requires occupation of a large space, which is not favorable for a high-density and high-speed routing layout. Moreover, the method introduces extra impedance discontinuity and reduces the anti-interference capability of a differential channel, leading to a decrease in the signal transmission quality.

On the other hand, components such as a high-speed connector, a ball grid array (BGA) package, and a high-speed layer-changing via in the high-speed system are basically differential vias. A calculation formula for impedance of the differential via is as follows:

$$Z = \frac{120\,\Omega}{\sqrt{\varepsilon}} \ln\left( \frac{s}{d} + \sqrt{\left(\frac{s}{d}\right)^2 - 1} \right)$$

In the above formula, Z denotes impedance of the differential via, S denotes a first spacing, d denotes a diameter of the differential via (i.e., a hole diameter of the differential via), and $\varepsilon$ denotes a dielectric constant of the PCB. According to the calculation formula for the impedance of the differential via, it can be seen that the impedance may be increased by reducing the hole diameter of the differential via, upgrading the board, and increasing a distance between the differential via and a reference medium. However, taking a connector signal hole as an example, a via size cannot be changed for proper crimping. Additionally, upgrading a board grade will significantly increase product costs, and an excessive distance between the signal hole and the reference medium may cause some high-speed lines to lose reference, introducing additional crosstalk.

In view of this, an embodiment of the present disclosure provides a printed circuit board, an electronic device, and a method for controlling a propagation delay skew of a differential pair, to reduce the propagation delay skew of differential signals.

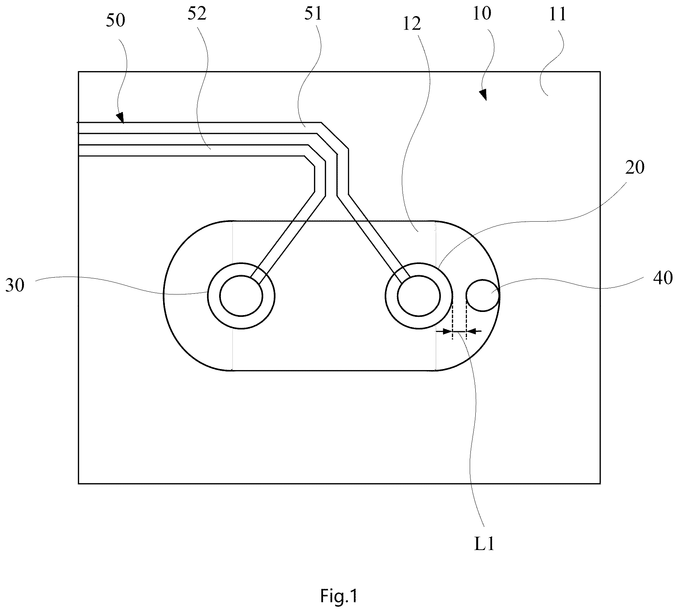

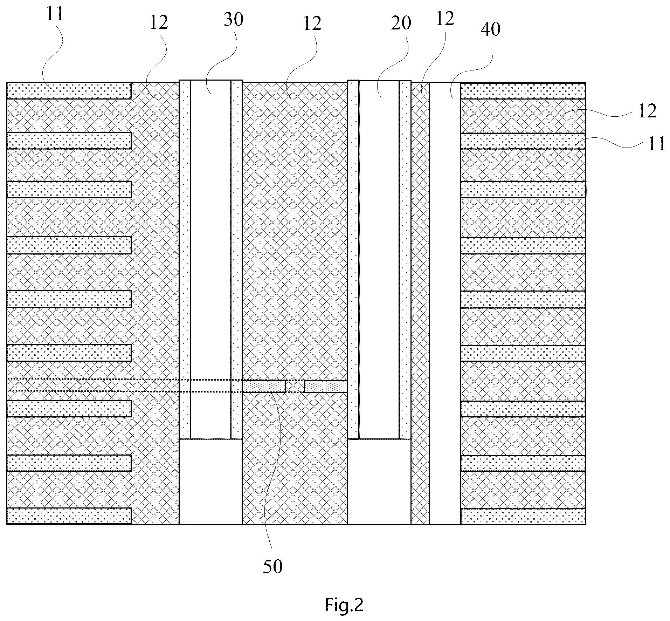

Referring to Fig. 1 and Fig. 2, an embodiment of the present disclosure provides a printed circuit board, including a board body 10. The board body 10 is provided with a first differential via 20, a second differential via 30, and at least one non-metallized hole 40. The first differential via 20 and the second differential via 30 form a differential via pair. The at least one non-metallized hole 40 is arranged around a periphery of the first differential via 20 and/or a periphery of the second differential via 30. The non-metallized holes 40 around the periphery of the first differential via 20 and the non-metallized holes 40 around the periphery of the second differential via 30 are asymmetrically arranged.

According to the printed circuit board in the above embodiment, the non-metallized holes 40 are arranged around the periphery of the differential via pair, and the non-metallized holes 40 around the periphery of the first differential via 20 and the non-metallized holes 40 around the periphery of the second differential via 30 are asymmetrically arranged, to reduce an effective dielectric constant of media around the peripheries of the corresponding differential vias, thereby adjusting the propagation delay skew of the differential signals of the differential vias, and then reducing the propagation delay skew of the differential signals of the differential pair; and by adjusting the impedance of the differential vias, impedance continuity of the differential pair is improved, and the transmission quality of the differential signals is improved. Additionally, the printed circuit board in this embodiment is simple in structure, easy to machine, high in operability, small in occupied space, and beneficial for high-density and high-speed routing.

It should be understood that the periphery of the differential via refers to an area surrounding the differential via, with a preset distance from the periphery of the differential via to a via wall of the differential via. The preset distance is designed according to actual requirements. This embodiment does not limit a specific value of the preset distance.

Referring to Fig. 1, exemplarily, the differential pair includes the first differential via 20, a first differential line 51, the second differential via 30, and a second differential line 52. The first differential line 51 and the first differential via 20 are connected. The second differential line 51 and the second differential via 30 are connected.

It should be understood that the differential signal in the differential pair refers to a signal transmitted on the differential pair.

Exemplarily, the non-metallized hole 40 and the first differential via 20 are not interconnected. The non-metallized hole 40 and the second differential via 30 are not interconnected.

It should be understood that relative dielectric constants of the medium around the periphery of the first differential via 20 and the medium around the periphery of the second differential via 30 are greater than a relative dielectric constant of the non-metalized holes 40, and therefore the non-metallized holes 40 arranged around the periphery of the first differential via 20 and/or the periphery of the second differential via 30 can reduce the effective dielectric constant of the medium around the peripheries/periphery of the first differential via 20 and/or the second differential via 30. It should be understood that a metallized hole is formed in the medium to form the first differential via 20 or the second differential via 30. The medium is, for example, a dielectric medium 12 described below.

Exemplarily, a spacing distance between the non-metallized holes 40 around the periphery of the first differential via 20 and the first differential via 20 is a first spacing. A spacing distance between the non-metallized holes 40 around the periphery of the second differential via 20 and the second differential via 20 is a second spacing. When a routing length of the first differential line 51 is greater than a routing length of the second differential line 52, according to the above calculation formula for the skew of the differential pair, a first preset method is used to reduce the effective dielectric constant of the medium around the periphery of the first differential via 20; or, the first preset method is used to reduce the effective dielectric constant of the media around the peripheries of the first differential via 20 and the second differential via 30, and a reduction range of the effective dielectric constant of the medium around the periphery of the first differential via 20 is greater than a reduction range of the effective dielectric constant of the medium around the periphery of the second differential via 30. Therefore, the propagation delay skew of the differential signal of the first differential via 20 can be adjusted, thereby reducing the propagation delay skew of the differential signal of the differential pair. The first preset method includes at least one of the following: the number of the non-metallized holes 40 around the periphery of the first differential via 20 is greater than the number of the non-metallized holes 40 around the periphery of the second differential via 30; a radius of the non-metallized holes 40 around the periphery of the first differential via 20 is greater than a radius of the non-metallized holes 40 around the periphery of the second differential via 30; and the first spacing is smaller than the second spacing.

Exemplarily, when the routing length of the first differential line 51 is less than the routing length of the second differential line 52, according to the above calculation formula for the skew of the differential pair, a second preset method is used to reduce the effective dielectric constant of the medium around the periphery of the second differential via 20; or, the second preset method is used to reduce the effective dielectric constant of the media around the peripheries of the first differential via 20 and the second differential via 30, and the reduction range of the effective dielectric constant of the medium around the periphery of the first differential via 20 is less than the reduction range of the effective dielectric constant of the medium around the periphery of the second differential via 30. Therefore, the propagation delay skew of the differential signal of the second differential via 30 can be adjusted, thereby reducing the propagation delay skew of the differential signal of the differential pair. The second preset method includes at least one of the following: the number of the non-metallized holes 40 around the periphery of the first differential via 20 is smaller than the number of the non-metallized holes 40 around the periphery of the second differential via 30; the radius of the non-metallized holes 40 around the periphery of the first differential via 20 is smaller than the radius of the non-metallized holes 40 around the periphery of the second differential via 30; and the first spacing is greater than the second spacing.

Referring to Fig. 1 and Fig. 2, in some embodiments, the board body 10 includes reference structures 11 and the dielectric medium 12. The dielectric medium 12 is filled between the reference structures 11, the first differential via 20, and the second differential via 30. The non-metallized hole 40 is arranged in the dielectric medium 12. Alternatively, the non-metallized hole 40 is arranged in the dielectric medium 12 and the reference structures 11.

Exemplarily, a plurality of reference structures 11 are included. A space between the adjacent reference structures 11 is filled with the dielectric medium 12.

Exemplarily, the relative dielectric constant of the dielectric medium 12 ranges from 2.9 to 4.5, such as 2.9, 3.0, 3.5, 4.0, 4.5, and any other suitable value within the range of 2.9 to 4.5. It should be understood that the non-metallized hole 40 is filled with air and has the relative dielectric constant of 1, and therefore combined use of the dielectric medium 12 and the non-metallized hole 40 can reduce the effective dielectric constant of the corresponding differential via reference structure, thereby increasing a signal transmission speed of the differential via, adjusting the problem about the inconsistent signal transmission speed of the differential pair, and reducing the propagation delay skew of the differential signals of the differential pair.

Exemplarily, both the first differential via 20 and the second differential via 30 are metallized holes.

Exemplarily, the differential via pair is provided with a pair of differential lines, namely a differential line pair 50. The differential line pair 50 includes the first differential line 51 and the second differential line 52. A line-outlet position of the first differential via 20 is connected with the first differential line 51. A line-outlet position of the second differential via 30 is connected with the second differential line 52.

Referring to Fig. 1, exemplarily, the first differential line 51 and the second differential line 52 are differential lines of unequal lengths, with a propagation delay skew between them. By asymmetrically arranging the non-metallized holes 40 around the periphery of the first differential via 20 and the non-metallized holes 40 around the periphery of the second differential via 30, the propagation delay skew of the differential signals in the differential pair can be reduced.

Exemplarily, a via wall surface of the non-metallized hole 40 is not plated, and the via is not plugged. The non-metallized hole 40 is completely filled with air.

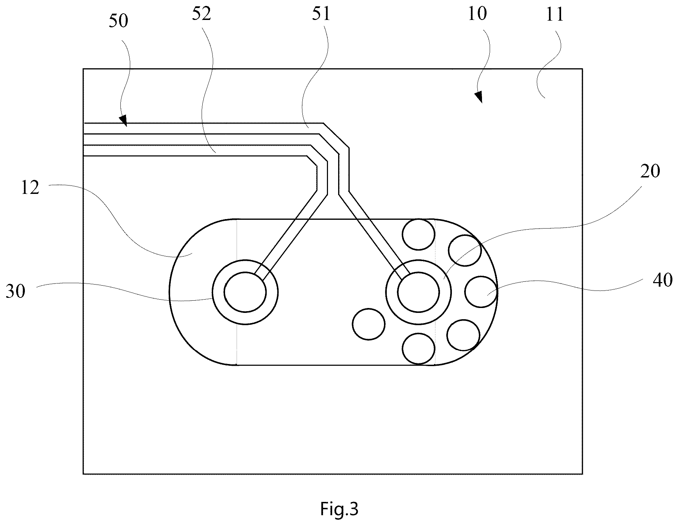

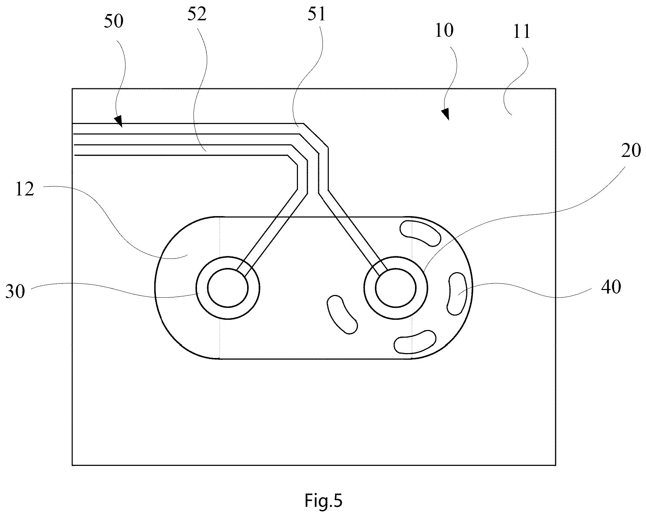

The number of non-metallized holes 40 may be designed according to actual requirements. Exemplarily, the number of the non-metallized holes 40 is one or more, such as one, two, three, four, five, six, or more. Exemplarily, referring to Fig. 1 and Fig. 2, one non-metallized hole 40 is provided, and is arranged around the periphery of the first differential via 20 or the second differential via 30. Referring to Fig.3 to Fig. 6, exemplarily, a plurality of non-metallized holes 40 are included.

The radius and the position of the non-metallized hole 40, as well as a spacing L1 (please refer to Fig.1) between the non-metallized hole 40 and the corresponding differential via, may all be designed according to simulation, manufacturer processing capabilities, etc. Referring to Fig.3 to Fig. 6, exemplarily, a plurality of non-metallized holes 40 are included, and the radii of the non-metallized holes 40 may be all the same, partially the same, partially different, or completely different. The spacing L1 between each non-metallized hole 40 and the corresponding differential via may be the same, partially the same, partially different, or completely different. It should be understood that the smaller the spacing L1 between the non-metallized hole 40 and the corresponding differential via, and the larger the radius of the non-metallized hole 40, the faster the differential signal transmission speed of the differential via corresponding to the non-metallized hole 40.

Exemplarily, at least three non-metallized holes 40 are included. A spacing between the adjacent non-metallized holes 40 is L2, and each L2 may be completely the same, partially the same, or completely different.

It should be understood that at least one non-metallized hole 40 is arranged around the periphery of the first differential via 20 and/or the periphery of the second differential via 30. The asymmetric arrangement of the non-metallized holes 40 around the peripheries of the first differential via 20 and the second differential via 30 includes at least one of the following: the number of the non-metallized holes 40 around the periphery of the first differential via 20 is different from the number of the non-metallized holes 40 around the periphery of the second differential via 30; the radius of the non-metallized holes 40 around the periphery of the first differential via 20 is different from the radius of the non-metallized holes 40 around the periphery of the second differential via 30; and the positions of the non-metallized holes 40 around the periphery of the first differential via 20 are asymmetrically located relative to the positions of the non-metallized holes 40 around the periphery of the second differential via 30. Exemplarily, the number of the non-metallized holes 40 around the periphery of the first differential via 20 is different from the number of the non-metallized holes 40 around the periphery of the second differential via 30, including: arranging the non-metallized holes 40 only around the periphery one of the first differential via 20 and/or the second differential via 30; or, arranging the non-metallized holes 40 around the peripheries of both the first differential via 20 and the second differential via 30, and the non-metallized holes 40 around the periphery of the first differential via 20 and the non-metallized holes 40 around the periphery of the second differential via 30 being asymmetrically arranged.

Referring to Fig. 1 to Fig. 3, and Fig. 5, in some embodiments, at least one non-metallized hole 40 is arranged around the periphery of the first differential via 20 or the second differential via 30. Exemplarily, the number of the non-metallized holes 40 arranged around the periphery of one of the first differential via 20 and the second differential via 30 is zero, and all non-metallized holes 40 are arranged around the periphery of the other one of the first differential via 20 and the second differential via 30, thereby achieving the asymmetric arrangement of the non-metallized holes 40 around the periphery of the first differential via 20 and the non-metallized holes 40 around the periphery of the second differential via 30.

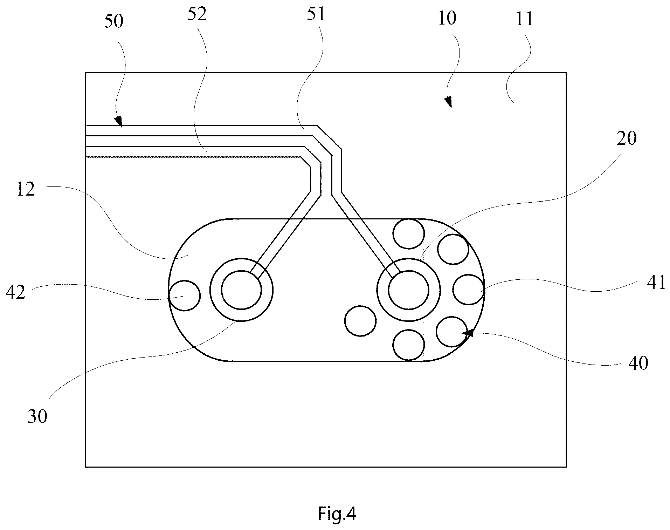

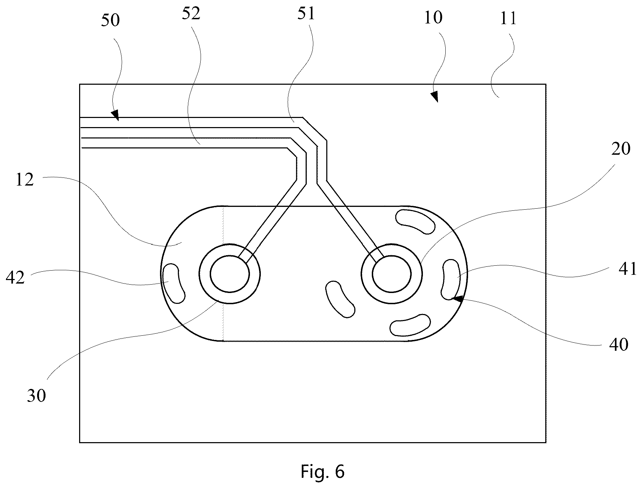

Referring to Fig. 4 and Fig. 6, in some embodiments, a part of the at least one non-metallized hole 40 is arranged around the periphery of the first differential via 20, and the other part of the at least one non-metallized hole 40 is arranged around the periphery of the second differential via 30. The non-metallized holes 40 around the periphery of the first differential via 20 and the non-metallized holes 40 around the periphery of the second differential via 30 are asymmetrically arranged.

Referring to Fig. 4 and Fig. 6, in some implementations, the at least one non-metallized hole 40 includes at least one first non-metallized hole 41 and at least one second non-metallized hole 42. The at least one first non-metallized hole 41 is arranged around the periphery of the first differential via 20. The at least one second non-metallized hole 42 is arranged around the periphery of the second differential via 30. The at least one first non-metallized hole 41 and the at least one second non-metallized hole 42 are asymmetrically arranged. Therefore, the asymmetric arrangement of the non-metallized holes 40 around the periphery of the first differential via 20 and the non-metallized holes 40 around the periphery of the second differential via 30 can be achieved.

It should be understood that the number of the first non-metallized holes 41 and the second non-metallized holes 42 may be designed according to actual requirements, such as one, two, three, or more.

Referring to Fig.4 and Fig. 6, in some implementations, a plurality of first non-metallized holes 41 are included. The plurality of first non-metallized holes 41 are arranged around the periphery of the first differential via 20 at intervals in a circumferential direction of the first differential via 20.

Referring to Fig. 4 and Fig. 6, in some implementations, the number of the non-metallized holes 40 around the periphery of the first differential via 20 is different from the number of the non-metallized holes 40 around the periphery of the second differential via 30, thereby achieving the asymmetric arrangement of the non-metallized holes 40 around the periphery of the first differential via 20 and the non-metallized holes 40 around the periphery of the second differential via 30. Exemplarily, the number of the non-metallized holes 40 around the periphery of the first differential via 20 is greater than the number of the non-metallized holes 40 around the periphery of the second differential via 30. Exemplarily, the number of the non-metallized holes 40 around the periphery of the first differential via 20 is less than the number of the non-metallized holes 40 around the periphery of the second differential via 30.

In some implementations, the radius of the non-metallized holes 40 around the periphery of the first differential via 20 is different from the radius of the non-metallized holes 40 around the periphery of the second differential via 30, thereby achieving the asymmetric arrangement of the non-metallized holes 40 around the periphery of the first differential via 20 and the non-metallized holes 40 around the periphery of the second differential via 30. Exemplarily, the radius of at least one of the at least one first non-metallized hole 41 is different from the radius of at least one of the at least one second non-metallized hole 42.

In some implementations, the position of at least one non-metallized hole 40 around the periphery of the first differential via 20 is asymmetrical to the position of at least one non-metallized hole 40 around the periphery of the second differential via 30, thereby achieving the asymmetric arrangement of the non-metallized holes 40 around the periphery of the first differential via 20 and the non-metallized holes 40 around the periphery of the second differential via 30.

Exemplarily, the number of the non-metallized holes 40 around the periphery of the first differential via 20 is the same as the number of the non-metallized holes 40 around the periphery of the second differential via 30, and the position of at least one non-metallized hole 40 around the periphery of the first differential via 20 is asymmetrical to the position of at least one non-metallized hole 40 around the periphery of the second differential via 30.

Referring to Fig. 4 and Fig. 6, exemplarily, the number of the non-metallized holes 40 around the periphery of the first differential via 20 is greater than the number of the non-metallized holes 40 around the periphery of the second differential via 30, and the positions of the second non-metallized holes 42 around the periphery of the second differential via 30 are symmetrical to the positions of some of the first non-metallized holes 41 around the periphery of the first differential via 20.

Exemplarily, the number of the non-metallized holes 40 around the periphery of the first differential via 20 is greater than the number of the non-metallized holes 40 around the periphery of the second differential via 30, and the positions of the second non-metallized holes 42 around the periphery of the second differential via 30 are asymmetrical to the position of any one of the first non-metallized holes 41 around the periphery of the first differential via 20.

In some implementations, a minimum distance (e.g., L1 in Fig. 1) between a via wall of the first differential via 20 or a via wall of the second differential via 30 and a hole wall of the non-metallized hole 40 is 2 mil to 20 mil, such as 2 mil, 4 mil, 8 mil, 10 mil, 15 mil, 20 mil, and any other suitable value between 2 mil and 15 mil. Exemplarily, the minimum distance L1 between the via wall of the first differential via 20 and a hole wall of the first non-metallized hole 41 is 2 mil to 20 mil. Exemplarily, the minimum distance between the via wall of the second differential via 30 and a via wall of the second non-metallized hole 42 is 2 mil to 20 mil.

Referring to Fig.1, Fig. 3, and Fig. 5, in some embodiments, the non-metallized hole 40 includes at least one of a circular hole, a kidney-shaped hole, a square hole, an arc hole, an oval hole, etc. Exemplarily, when the non-metallized hole 40 is a non-circular hole, the radius of the non-metallized hole 40 is equal to half of a width of the non-metallized hole 40.

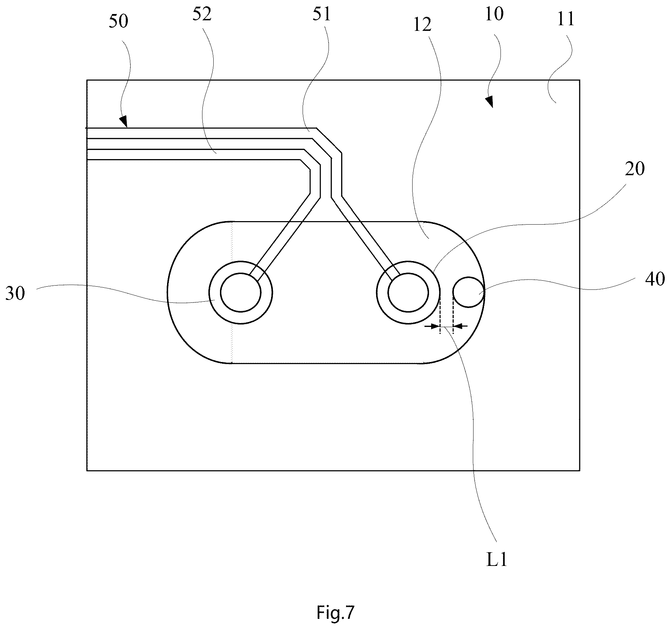

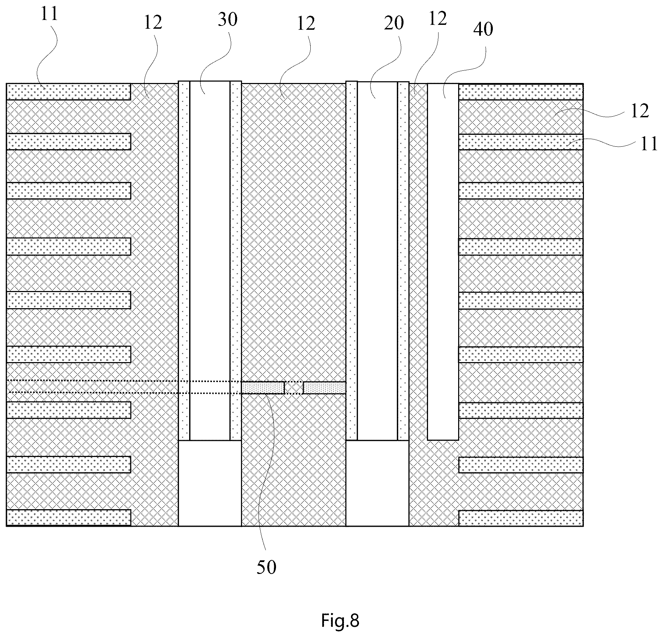

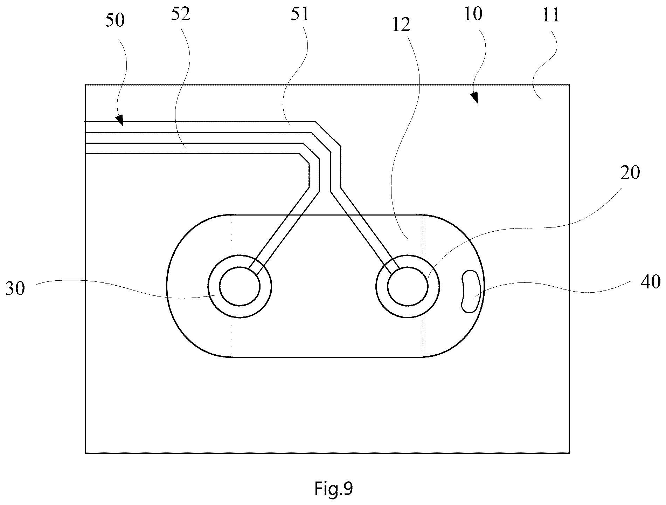

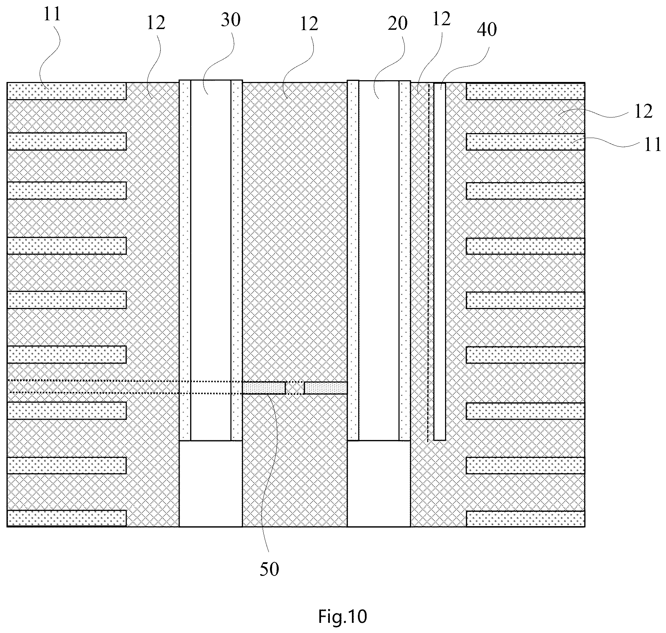

Referring to Fig. 2, and Fig. 7 to Fig. 10, in some embodiments, the non-metallized hole 40 includes a non-metallized through hole, a non-metallized blind hole, or a non-metallized buried hole. Exemplarily, considering the routing density in the printed circuit board and no damage to the integrity of a power plane, the non-metallized hole 40 includes the non-metallized blind hole or the non-metallized buried hole, and a depth of the non-metallized hole 40 may be set according to actual requirements.

The performance of a printed circuit board without non-metallized holes 40 (a control group, S0) and the performance of the printed circuit board (S1) in this embodiment of the present disclosure are compared below.

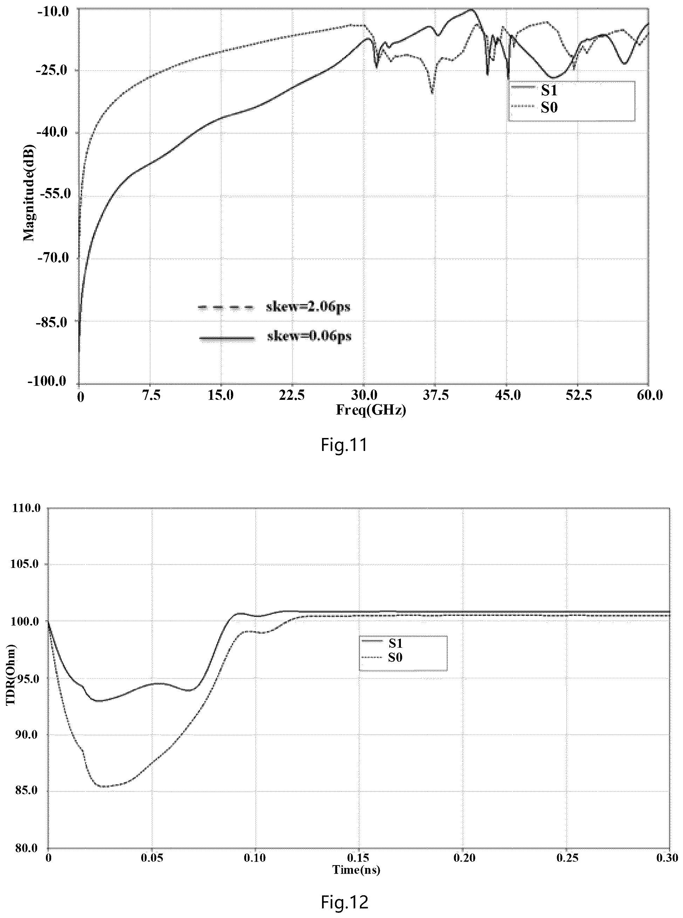

Referring to Fig. 11, Fig. 11 is a mode conversion diagram for the control group and the printed circuit board according to this embodiment of the present disclosure. In Fig. 11, a horizontal axis represents a signal frequency, and a vertical axis represents a signal amplitude.As can be seen from Fig. 11, a skew (a propagation delay skew) value of a differential signal of a differential pair in the control group is 2.06 ps, while a skew value of the differential signal of the differential pair in the printed circuit board of this embodiment is 0.06 ps.It can be inferred that according to the printed circuit board in this embodiment, by arranging the at least one non-metallized hole 40 around the periphery of the first differential via 20 and/or the periphery of the second differential via 30 and asymmetrically arranging the non-metallized holes 40 around the periphery of the first differential via 20 and the non-metallized holes 40 around the periphery of the second differential via 30, the signal transmission speed of the differential vias can be increased, the skew value of the differential signals is reduced or improved, the signal transmission quality is improved, and the routing space is increased.

Referring to Fig. 12, Fig. 12 is an impedance diagram for a control group and the printed circuit board according to this embodiment of the present disclosure. In Fig. 12, a horizontal axis represents propagation time, and a vertical axis represents impedance of a differential pair. As can be seen from Fig. 12, according to the printed circuit board in this embodiment, by arranging the at least one non-metallized hole 40 around the periphery of the first differential via 20 and/or the periphery of the second differential via 30 and asymmetrically arranging the non-metallized holes 40 around the periphery of the first differential via 20 and the non-metallized holes 40 around the periphery of the second differential via 30, the impedance can be increased, the impedance continuity of a system link is improved, insertion loss fluctuations are reduced, and signal reflections are reduced.

An embodiment of the present disclosure further provides an electronic device, including the printed circuit board according to any one of the above embodiments.

An embodiment of the present disclosure further provides a method for controlling a propagation delay skew of a differential pair on a printed circuit board, including:

arranging at least one non-metallized hole 40 around a periphery of a first differential via 20 and/or a periphery of a second differential via 30, where the first differential via 20 and the second differential via 30 form a differential via pair, and the non-metallized holes 40 around the periphery of the first differential via 20 and the non-metallized holes 40 around the periphery of the second differential via 30 are asymmetrically arranged.

According to the method for controlling a propagation delay skew of a differential pair on a printed circuit board in the above embodiment, by arranging the non-metallized holes 40 around the periphery of the first differential via 20 and/or the periphery of the second differential via 30, and asymmetrically arranging the non-metallized holes 40 around the periphery of the first differential via 20 and the non-metallized holes 40 around the periphery of the second differential via 30, an effective dielectric constant of media around the peripheries of the corresponding differential vias is reduced, thereby adjusting the propagation delay skew of differential signals of the differential vias, and then reducing the propagation delay skew of the differential signals of the differential pair; and by adjusting the impedance of the differential vias, impedance continuity of the differential pair is improved, and the transmission quality of the differential signals is improved.

Exemplarily, the printed circuit board includes the printed circuit board according to any one of the above embodiments.

The printed circuit board and the method for controlling a propagation delay skew of a differential pair on a printed circuit board in the above embodiments may be applied to a multi-layer printed circuit board structure designed with BGA differential vias, high-speed connector crimp vias, high-speed layer-changing differential vias, etc., and is particularly suitable for a printed circuit board structure in a high-speed backpanel system with a rate of 112 Gbps or above.

It should be understood that the common practice for fan-out differential lines from the BGA differential vias is to adjust the equal length at via positions. As a signal rate increases, a pitch spacing of BGA differential signal holes may decrease to 0.6 mm, making it impossible to adjust fan-out lines from the differential vias to achieve the equal length for the fan-out differential lines from the BGA vias. Therefore, the differential lines need to be internally adjusted to be equal in length outside the BGA, which introduces additional impedance discontinuous points. Therefore, the skew of the differential vias may be adjusted and the impedance discontinuous points may be reduced by arranging a certain number of non-metallized holes 40 around a periphery of a via with a longer trace in a BGA fan-out differential pair. A drilling diameter and the number of the non-metallized holes 40 may be obtained through simulation, and placement positions need to satisfy manufacturability.

It should be understood that the skew of the system link may be adjusted through crimp via positions of a connector in a channel. Since the connector crimp vias are relatively far from surrounding signal holes or grounding shield holes, a larger number of non-metallized holes 40 with larger diameters/slot widths may be placed to adjust the problem of inconsistent transmission speeds in the differential pair. Additionally, the drilling diameters of differential vias for the connector on the printed circuit board mostly range from 0.32 mm to 0.6 mm, and the hole diameters are relatively large, causing that the impedance of the differential vias is significantly lower than that of the system link. Moreover, the differential vias for the connector on the printed circuit board are the crimp holes required to mate with the connector for crimping, and therefore, modification cannot be achieved. By arranging the non-metallized holes 40 around the differential via pair, the impedance of the differential vias can be increased to some extent while improving the skew, thereby enhancing the impedance continuity of the link.

It should be understood that the high-speed layer-changing differential vias are applied to a scenario where a high-speed link needs replacement of a routing layer, which are common in the printed circuit board. Similar to an application scenario of BGA fan-out differential vias, the non-metallized holes 40 may be arranged around one of signal holes of the high-speed layer-changing vias to adjust the skew value of a high-speed differential signal and reduce the discontinuous points in the system link. Typically, only return ground vias are arranged around the high-speed layer-changing differential vias, allowing for the placement of more non-metallized holes 40 with larger diameters. However, the routing of nearby high-speed signals cannot be interfered.

In the description of the embodiments of the present disclosure, it should be noted that, unless otherwise explicitly specified and limited, the terms "mounted", "connected", "linked", "mechanically coupled", and "coupled" are to be understood in a broad sense. For example, a connection may be a fixed connection, a detachable connection, or an integral connection. Alternatively, the connection may be a mechanical connection or an electrical connection. Alternatively, the connection may be a direct connection, an indirect connection through an intermediary, or internal communication between two elements, or an interaction relationship between two elements. Mechanical coupling or coupling between two components includes direct coupling and indirect coupling, such as a direct fixed connection and a connection through a transmission mechanism. Those of ordinary skill in the art may understand the specific meanings of the foregoing terms in the present disclosure according to specific situations.

In the embodiments of the present disclosure, unless otherwise expressly specified and limited, a first feature being "above" or "below" a second feature may include direct contact of the first feature and the second feature, or may also include indirect contact of the first feature and the second feature through an additional feature therebetween. In addition, the first feature being "over", "above", and "on" the second feature includes the first feature being over and above the second feature, or merely indicates that a level of the first feature is higher than that of the second feature. The first feature being "under", "below", and "underneath" the second feature includes the first feature being under and below the second feature, or merely indicates that the level of the first feature is lower than that of the second feature.

The above disclosure provides many different implementations or examples for implementing different structures of the present disclosure. To simplify the present disclosure, components and settings in particular examples are described above. Certainly, they are merely examples and are not intended to limit the present disclosure. Further, the embodiments of the present disclosure may reuse reference numerals and/or reference letters across different examples for simplicity and clarity, which does not indicate any relationship between the various implementations and/or settings discussed. Moreover, the embodiments of the present disclosure provide examples of various particular processes and materials, but those of ordinary skill in the art may be aware of applicability of another process and/or use of another material.

In the descriptions of this specification, descriptions using reference terms "an implementation", "some implementations", "an exemplary implementation", "an example", "a specific example", or "some examples" mean that specific method steps, features, structures, materials, or characteristics described with reference to the implementations or examples are included in at least one implementation or example of the present disclosure. In this specification, illustrative expressions of the above terms do not necessarily refer to the same implementation or example. Moreover, the described specific method steps, features, structures, materials, or characteristics may be combined in a suitable manner in any one or more of the implementations or examples.

The above contents are merely specific implementations of the present disclosure, but the scope of protection of the present disclosure is not limited thereto; and any technical personnel familiar with the technical field may easily think of various equivalent modifications or substitutions within the technical scope disclosed by the embodiments of the present disclosure, and these modifications or substitutions shall be included within the scope of protection of the present disclosure. Therefore, the scope of protection of the present disclosure should be based on the scope of protection of the claims.

**Claims**

1. A printed circuit board, comprising a board body, the board body being provided with a first differential via, a second differential via, and at least one non-metallized hole, and the first differential via and the second differential via forming a differential via pair; wherein the at least one non-metallized hole is arranged around a periphery of the first differential via and/or a periphery of the second differential via, and the non-metallized holes around the periphery of the first differential via and the non-metallized holes around the periphery of the second differential via are asymmetrically arranged.

2. The printed circuit board according to claim 1, wherein the at least one non-metallized hole is arranged around the periphery of the first differential via or the periphery of the second differential via.

3. The printed circuit board according to claim 1, wherein the at least one non-metallized hole comprises:

   at least one first non-metallized hole arranged around the periphery of the first differential via; and
   at least one second non-metallized hole, arranged around the periphery of the second differential via, and the at least one first non-metallized hole and the at least one second non-metallized hole are asymmetrically arranged.

4. The printed circuit board according to claim 3, wherein a plurality of first non-metallized holes are comprised and arranged around the periphery of the first differential via at intervals in a circumferential direction of the first differential via.

5. The printed circuit board according to claim 3, wherein the number of the non-metallized holes around the periphery of the first differential via is different from the number of the non-metallized holes around the periphery of the second differential via; and/or, a radius of the non-metallized holes around the periphery of the first differential via is different from a radius of the non-metallized holes around the periphery of the second differential via.

6. The printed circuit board according to claim 3, wherein positions of at least one non-metallized hole around the periphery of the first differential via are asymmetrical to positions of at least one non-metallized hole around the periphery of the second differential via.

7. The printed circuit board according to claim 1, wherein the non-metallized hole comprises at least one of a circular hole, a kidney-shaped hole, a square hole, an arc hole, and an oval hole.

8. The printed circuit board according to any one of claims 1 to 7, wherein the board body comprises:

   a reference structure; and
   a dielectric medium, filled between the reference structure, the first differential via, and the second differential via; and the non-metallized hole is arranged on the dielectric medium, or the non-metallized hole is arranged on the dielectric medium and the reference structure.

9. An electronic device, comprising the printed circuit board according to any one of claims 1 to 8.

**10.** A method for controlling a propagation delay skew of a differential pair on a printed circuit board, comprising:

arranging at least one non-metallized hole around a periphery of a first differential via and/or a periphery of a second differential via, the first differential via and the second differential via forming a differential via pair, and the non-metallized holes around the periphery of the first differential via and the non-metallized holes around the periphery of the second differential via being asymmetrically arranged.

Fig.1

Fig.2

Fig.3

Fig.4

Fig.5

Fig. 6

Fig.7

11  12  30  12  20  12  40

12

11

50

Fig.8

Fig.9

Fig.10

Fig.11

Fig.12

# INTERNATIONAL SEARCH REPORT

| International application No. |
| --- |
| **PCT/CN2023/102207** |

| A. | CLASSIFICATION OF SUBJECT MATTER |
| --- | --- |

H05K1/02(2006.01)i

According to International Patent Classification (IPC) or to both national classification and IPC

| B. | FIELDS SEARCHED |
| --- | --- |

Minimum documentation searched (classification system followed by classification symbols)

IPC: H05K

Documentation searched other than minimum documentation to the extent that such documents are included in the fields searched

Electronic data base consulted during the international search (name of data base and, where practicable, search terms used)

CNTXT; ENTXT; ENTXTC; DWPI; WPABS; CNKI; IEEE: 电路板, 印制, 印刷, 差分, 线, 孔, 非金属, 槽, 空腔, 挖空, 第一, 第二, 非对称, 不对称, 非等长, 长度, 不同, 不等, 不相同, 不相等, 差别, 阻抗, circuit board, printed, differential, line, hole, non-metal, groove, slot, cavity, hollowed, first, second, asymmetric, non-equal length, length, different, unequal, unequal, impedance

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | CN 1913742 A (HONGFUJIN PRECISION INDUSTRY (SHENZHEN) CO., LTD. et al.) 14 February 2007 (2007-02-14) <br> description, pp. 1 and 2, and figure 1 | 1-10 |
| Y | CN 102291929 A (FUJIAN STAR-NET RUIJIE NETWORK CO., LTD.) 21 December 2011 (2011-12-21) <br> description, paragraphs [0007]-[0066], and figures 5A-8C | 1-10 |
| A | CN 203896579 U (SHENZHEN FASTPRINT CIRCUIT TECHNOLOGY CO., LTD. et al.) 22 October 2014 (2014-10-22) <br> entire document | 1-10 |
| A | CN 110536548 A (SUZHOU INSPUR INTELLIGENT TECHNOLOGY CO., LTD.) 03 December 2019 (2019-12-03) <br> entire document | 1-10 |
| A | CN 114143961 A (CHINA AUTOMOTIVE INNOVATION CORP. TECHNOLOGY CO., LTD.) 04 March 2022 (2022-03-04) <br> entire document | 1-10 |

☑ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **15 September 2023** | **18 September 2023** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
|---|
| **PCT/CN2023/102207** |

### C.    DOCUMENTS CONSIDERED TO BE RELEVANT

| Category* | Citation of document, with indication, where appropriate, of the relevant passages | Relevant to claim No. |
|---|---|---|
| A | CN 109379832 A (52nd RESEARCH INSTITUTE OF CHINA ELECTRONICS TECHNOLOGY GROUP CORP.) 22 February 2019 (2019-02-22) <br> entire document | 1-10 |
| A | CN 107155258 A (ANHUI HONGXIN ELECTRONIC TECHNOLOGY CO., LTD.) 12 September 2017 (2017-09-12) <br> entire document | 1-10 |
| A | US 2021274648 A1 (CRAY INC.) 02 September 2021 (2021-09-02) <br> entire document | 1-10 |

Form PCT/ISA/210 (second sheet) (July 2022)

**INTERNATIONAL SEARCH REPORT**
Information on patent family members

International application No.

**PCT/CN2023/102207**

| Patent document cited in search report | | | Publication date (day/month/year) | Patent family member(s) | | | Publication date (day/month/year) |
|---|---|---|---|---|---|---|---|
| CN | 1913742 | A | 14 February 2007 | US | 2007075432 | A1 | 05 April 2007 |
| | | | | US | 7679168 | B2 | 16 March 2010 |
| | | | | CN | 100574552 | C | 23 December 2009 |
| CN | 102291929 | A | 21 December 2011 | None | | | |
| CN | 203896579 | U | 22 October 2014 | None | | | |
| CN | 110536548 | A | 03 December 2019 | WO | 2021051446 | A1 | 25 March 2021 |
| CN | 114143961 | A | 04 March 2022 | CN | 114143961 | B | 21 July 2023 |
| CN | 109379832 | A | 22 February 2019 | None | | | |
| CN | 107155258 | A | 12 September 2017 | CN | 107155258 | B | 10 May 2019 |
| US | 2021274648 | A1 | 02 September 2021 | US | 11343905 | B2 | 24 May 2022 |

Form PCT/ISA/210 (patent family annex) (July 2022)

**REFERENCES CITED IN THE DESCRIPTION**

**Patent documents cited in the description**

- CN 202211058162